# EUROPEAN PATENT SPECIFICATION

(11) **EP 0 830 811 B1**
(45) Date of publication and mention of the grant of the patent: **02.02.2000**
(21) Application number: 95923780.1
(22) Date of filing: 07.06.1995
(51) Int. Cl.: H05K 7/20, H05K 7/14

(54) **HEAT SINK WITH INTEGRATED BUS BAR**
KÜHLKÖRPER MIT EINER INTEGRIERTEN STROMSCHIENE
PUITS DE CHALEUR A BARRE OMNIBUS INTEGREE

(43) Date of publication of application: 25.03.1998
(73) Proprietor: SMITHS INDUSTRIES AEROSPACE & DEFENSE SYSTEMS INC., Grand Rapids, Michigan 49518-8727 (US)
(72) Inventor: BUJTAS, Geza, Holmdel, NJ 07733 (US); HUPP, Robert, A., Manville, NJ 08835 (US)
(74) Representative: Smulders, Theodorus A.H.J., Ir.
(86) International application number: US9507339
(87) International publication number: WO9641510

(56) References cited:
- EP-A- 0 064 856
- EP-A- 0 277 546
- WO-A-94/14227
- GB-A- 2 107 526

## Description

### BACKGROUND OF THE INVENTION

### Field of the Invention

This invention relates to electrical circuit boards and, more particularly, to a circuit board assembly having a bus bar for distributing electrical current to several circuit modules provided on the circuit board and a heat sink for thermally conducting heat away from the circuit modules.

### Description of the Related Art

Circuit boards are typically made of an electrically insulating material and have multiple circuit modules mounted thereon. It is known to use multiple bus bars mounted on the front surface of the circuit board to conduct electrical current from a suitable source to multiple modules mounted on the front surface of the circuit board. It is also known to provide a heat sink adjacent the modules in order to thermally conduct heat away from the circuit board in order to protect the modules from the high heat generated as a result of the current flow through the modules (see for example GB-A-2 107 526).

It is desirable to incorporate bus bars into a circuit board for the efficient distribution of current from a single source to the multiple modules. Preferably, the number of bus bars would be minimized to reduce weight and material cost.

### SUMMARY OF THE INVENTION

The heat sink with an integrated bus bar according to the invention overcomes the problems of the prior art by permitting the utilization of a single bus bar for supplying electrical current to a large number of modules of an electrical circuit while providing means for effectively thermally conducting the heat generated in the electrical circuit away from the modules of the circuit board.

In one aspect, the invention as claimed comprises an electric circuit board assembly incorporating at least one circuit board, wherein multiple circuit modules are provided on the board. A bus bar is used to conduct electrical current from a suitable source of power to each of the circuit modules. The bus bar is provided between the two circuit boards and has multiple terminals formed thereon which are electrically connected to the circuit modules on both the circuit boards. A heat sink is also provided between the two circuit boards, and has at least one aperture provided therein to receive at least one of the bus bar terminals extending from the bus bar to one of the circuit modules of the second circuit board. The heat sink is adapted to thermally conduct heat away from the circuit modules.

Preferably, the heat sink also has a depression formed in the front surface thereof wherein the bus bar is received, at least in part, in the depression.

In another embodiment, the bus bar is electrically insulated from the heat sink and circuit boards.

In another aspect, the invention comprises an electrical circuit board assembly incorporating two circuit boards wherein each board has at least one circuit module provided thereon and each board has an outer edge. A bus bar is provided between the two circuit boards and has multiple terminals provided thereon. The terminals are electrically connected to the circuit modules on both the first and second circuit boards. A heat sink is also provided between the two circuit boards immediately adjacent to the bus bar. The heat sink extends outwardly from the circuit boards and has an outer edge extending beyond the outer edge of the circuit boards. The outer edge is adapted to contact the frame of a supporting chassis to thermally conduct heat away from the bus bar and circuit modules to the frame.

### BRIEF DESCRIPTION OF THE DRAWINGS

The invention will now be described with reference to the drawings in which:
FIG. 1 is a perspective view of an electrical circuit board incorporating the heat sink and bus bar according to the invention; and
FIG. 2 is an exploded, perspective view of the heat sink and bus bar assembly according to the invention.

### DETAILED DESCRIPTION OF THE PREFERRED EMBODIMENTS

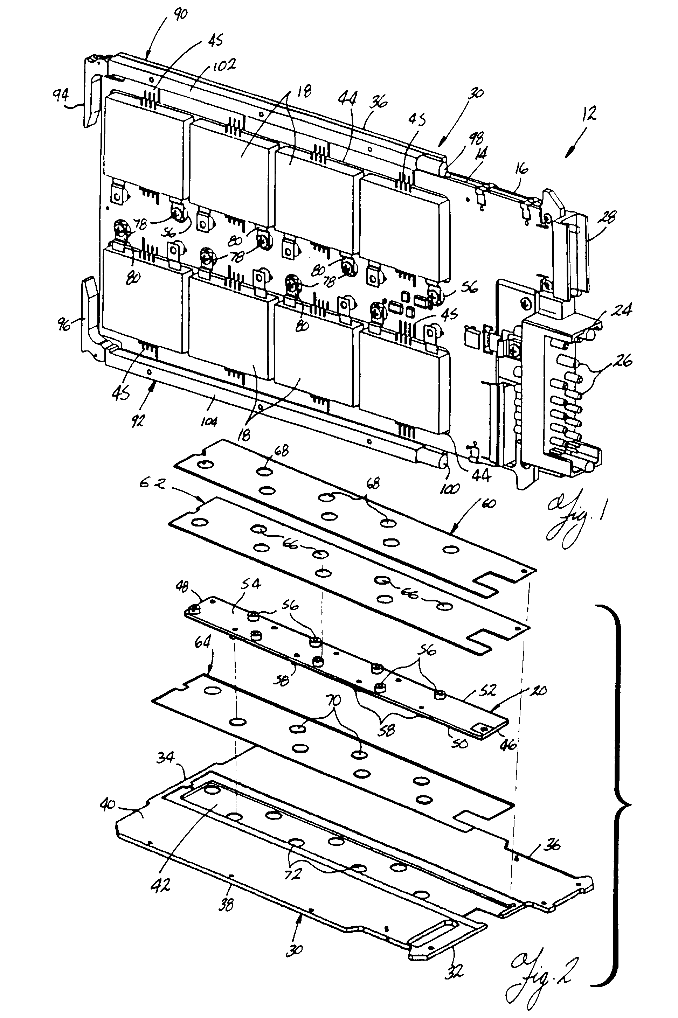

Referring now to the drawings and to FIGS. 1 and 2 in particular, a circuit board assembly 12 having an integrated heat sink and bus bar according to the invention is shown. The circuit board assembly 12 comprises first and second circuit boards 14, 16, respectively, provided parallel to and closely adjacent to one another. Each circuit board has a plurality of circuit modules 18 provided adjacent thereto and electrically connected thereto by conventional connections 45. Each of the modules 18 is electrically connected to a single bus bar 20 which is in turn selectively connected to a conventional power source (not shown). The particular structure of the circuit modules 18 is not critical to the invention and therefore will not be described in detail. In the preferred embodiment, the circuit board assembly is formed from two circuit boards. It is within the scope of this invention to utilize a single circuit board or more than two boards.

A conventional power terminal 24 is provided on one end of the circuit board assembly 12. The terminal 24 has a plurality of pins 26 provided thereon for providing suitable electrical connections. A conventional signal terminal 28 is also provided on the circuit board assembly adjacent the power terminal. The signal terminal is electrically connected to the circuit modules 18 and adapted to conduct electrical signals thereto.

A heat sink 30 is provided between the first and second circuit boards 14, 16. As described further below, the heat sink is adapted to thermally conduct heat away from the circuit boards 14, 16 and modules 18 provided thereon. The heat sink 30 is substantially planar and has a front edge 32, a rear edge 34 and a pair of opposed side edges 36, 38. The heat sink 30 further comprises a top surface 40, a bottom surface (not shown) and a depression, pocket or recess 42 provided in the top surface 40 for receipt of the bus bar 20. Preferably, the depression 42 is complementary to the shape of the bus bar 20 and has a sufficient depth to receive at least a portion of, if not all of, the entire thickness of the bus bar 20 therein. Preferably, the circuit modules 18 are mounted to the front and rear surfaces of the heat sink by a conventional thermally conductive adhesive (not shown). Module apertures 44 are provided in the circuit boards 14, 16 so that the modules 18 extend outwardly beyond the exposed surfaces of the circuit boards 14, 16. The heat sink is preferably formed from aluminum. However, any thermally conductive material is suitable.

The bus bar 20 comprises a front edge 46, a rear edge 48, a pair of opposed side edges 50, 52 and top 54 and bottom surfaces extending between the several edges. A plurality of bus bar terminals 56, 58 protrude laterally from the top and bottom surfaces, respectively, of the bus bar. The terminals are preferably integrally formed with the bus bar. However, the terminals can be mounted to the bus bar by conventional methods including welding or brazing. As described further below, the several terminals are electrically connected to the circuit modules 18 provided on the first and second circuit boards 14, 16. Preferably, the bus bar and terminals are formed from copper. However, any electrically conductive material can be utilized.

The bus bar 20 is received in the depression 42 and enclosed therein by a cover 60 which is secured to the heat sink 30 by a conventional adhesive. Preferably, the bus bar 20 is electrically insulated from the cover 60 and heat sink 30 by conventional insulation means. In FIG. 2, the bus bar 20 is insulated from the cover 60 and heat sink 30 by a pair of sheets of insulating film 62, 64 provided between the bus bar 20 and the cover 60 and heat sink 30, respectively. Examples of suitable material for the insulating film include TEDLAR^{™} and KAPTON^{™} . Alternatively, the bus bar or adjacent components could be electrically insulated by coating with a conventional epoxy powder coating. The insulating film 62 and cover 60 have terminal apertures 66, 68, respectively, formed therein which are adapted to receive the bus bar terminals 56. Similarly, the insulating film 64 and heat sink 30 have terminal apertures 70, 72 which are adapted to receive the bus bar terminals 58 protruding from the bottom surface (not shown) of the bus bar 20. The bus bar terminals 56, 58 extend through apertures 74 formed on the circuit boards 14, 16 such that the terminals are exposed and available for connection to the circuit modules 18.

The circuit modules 20 are electrically connected to the bus bar terminals 56, 58 by conventional fasteners 78 which secure conventional electrical leads 80 of the modules 20 to the terminals 56, 58. Although the preferred embodiment discloses terminals 56, 58 which protrude outwardly from the bus bar 20, it is certainly within the scope of the invention to provide electrical conduits which protrude inwardly from the circuit modules 18 to contact the bus bar 20.

As seen in FIG. 1, a single buss bar 20 is utilized to distribute electrical current to multiple circuit modules 18 on the first circuit board 14. Similarly, multiple circuit modules 18 are provided on the second circuit board all of which can be electrically connected to the same bus bar 20. In the preferred embodiment, 16 different circuit modules, eight on the first circuit board 14 and eight on the second circuit board 16, are electrically connected to the buss bar 20.

As noted above, the first and second circuit boards 14, 16 are provided closely adjacent to one another with the heat sink, bus bar 20 and cover 60 provided intermediate the two circuit boards 14, 16. The side edges 36, 38 of the heat sink extend beyond the top and bottom sides 84, 86 and 88 of the first and second circuit boards 14, 16. The side edges 36, 38 of the heat sink 30 are adapted to contact the conventional rails (not shown) of the chassis which receive the circuit board and thermally conduct the heat generated in the circuit board assembly 12 to the chassis. Conventional wedge clamps 90, 92 are provided on the top and bottom side edges 36, 38 of the heat sink for maximizing the contact pressure between the top and bottom edges of the heat sink and the chassis rails. The wedge clamps 90, 92 comprise actuator levers 94, 96 which are interconnected to translating shafts 98, 100 received inside a cam housing 102, 104. As the actuator lever 94, 96 is rotated from the relaxed position to the engaged position as seen in FIG. 1, the shafts 98, 100 translate thereby causing cam members provided inside the cam housing 102, 104 to slide with respect to one another thereby expanding the cam housings 102, 104 laterally with respect to the heat sink 30 and circuit board 14, 16. This lateral expansion causes the side edges 36, 38 of the heat sink 30 and cam housings 102, 104 to occupy substantially all of the space of the conventional rail provided in the chassis. Therefore, maximum surface contact and pressure is achieved between the edges 36, 38 of the heat sink 30 and the chassis.

The electrical circuit board assembly according to the invention utilizes a single bus bar to conduct electrical current to circuit modules provided on two closely adjacent circuit boards. Because of the large amount of heat which will likely be generated by the modules, the heat sink is provided immediately adjacent the modules and adapted to thermally conduct heat away from the circuit modules. As noted above, the bus bar is preferably imbedded into the heat sink. Preferably, the cover which encloses the bus bar in the heat sink recess is electrically insulated such that the bus bar is substantially encapsulated inside the thermally conductive heat sink. By enclosing the bus bar and imbedding it into the heat sink, the bus bar is effectively shielded from inadvertent contact by individuals or loose objects in and around the circuit board assembly.

Another advantage of the structure according to the invention is the ability to use a single bus bar and heat sink for two opposed, closely adjacent circuit boards. An electrical circuit assembly according to the invention effectively combines two circuit boards and modifies the structure of the heat sink and bus bar such that only a single bus bar and heat sink can be utilized for two different circuit boards. This results in material cost savings and weight reduction.

Still another advantage of the structure according to the invention is the adaptability of the structure. For example, if a bus bar is imbedded between a single circuit board and a heat sink, this single circuit board assembly could be easily modified to attach a second circuit board thereto and utilize the same bus bar by merely securing the second circuit board to the heat sink side of the original structure and electrically connecting the modules of the second board to the bus bar.

Reasonable variation and modification are possible without departing from the scope of the invention.

## Claims

1. An electrical circuit board assembly comprising a first circuit board (14) having a front surface and a rear surface, a second circuit board (16) having a front surface and a rear surface, the circuit boards being provided parallel to one another such that the rear surfaces are opposed and adjacent to one another, and a plurality of circuit modules (18) provided on at least one of the surfaces of the first and second circuit boards, the assembly further comprising:
a bus bar (20) provided intermediate the first and second circuit boards and adjacent to the rear surface of the first circuit board, the bus bar being electrically connected to at least one of the circuit modules provided on the first circuit board and at least one of the circuit modules provided on the second circuit board;
a heat sink (30) provided intermediate the first and second circuit boards and adjacent to both the bus bar and the rear surface of the second circuit board, the heat sink being adapted to thermally conduct heat from the bus bar and circuit modules away therefrom and comprising front and rear surfaces; and
a cover (60) provided on the front surface of the heat sink, the cover having at least one aperture (68) formed therein for receipt of an electrical connection extending between the buss bar and at least one of the circuit modules of the first circuit board, so that the bus bar can be electrically connected to circuit modules provided on both the first and second circuit boards.

2. An electrical circuit board assembly according to claim 1 wherein eight apertures are formed in the cover and eight circuit modules are provided on the first circuit board and are electrically connected to the bus bar through eight electrical connection conduits extending through the eight apertures between the buss bar and the cover.

3. An electrical circuit board assembly according to claim 1 wherein the cover, in cooperation with the heat sink, substantially encloses the bus bar.

4. An electrical circuit board assembly according to claim 1 and further comprising insulating material provided between the cover and the bus bar such that the buss bar and heat sink are electrically insulated from one another.

5. An electrical circuit board assembly according to claim 4 and further comprising insulating material (62,64) provided between the heat sink and the bus bar such that the buss bar and heat sink are electrically insulated from one another.

6. An electrical circuit board assembly comprising a first circuit board (14) having a front surface and a rear surface, a second circuit board (16) having a front surface and a rear surface, the circuit boards being provided parallel to one another such that the rear surfaces are opposed and adjacent to one another, and a plurality of circuit modules (18) provided on at least one of the surfaces of the first and second circuit boards, the assembly comprising:
a bus bar (20) provided intermediate the first and second circuit boards and adjacent to the rear surface of the first circuit board, the bus bar being electrically connected that least one of the circuit modules (18) provided on the first circuit board and at least one of the circuit modules provided on the second circuit board;
a heat sink (30) provided intermediate the first and second circuit boards and adjacent to both the bus bar and the rear surface of the second circuit board, the heat sink being adapted to thermally conduct heat from the bus bar and circuit modules away therefrom; and
a cover (60) provided on the front surface of the heat sink, the cover having at least one aperture (68) formed therein for receipt of an electrical connection extending between the bus bar and at least one of the circuit modules of the first circuit board, so that the bus bar can be electrically connected to circuit modules provided on both the first, and second circuit boards;
the heat sink (30) comprising eight aperture (72) and eight circuit modules are provided on the second circuit board and are electrically connected to the bus bar through eight electrical connection conduits extending through the eight apertures between the bus bar and the heat sink.

7. An electrical circuit board assembly according to claim 6 wherein eight circuit modules are provided on the first circuit board and electrically connected to the bus bar.

8. An electrical circuit board assembly comprising:
a first circuit board (14) having a front surface, a rear surface and at least one circuit module (18) electrically connected to at least one of the front and rear surfaces
a buss bar (20) provided adjacent the rear surface of the first circuit board, the bus bar having a plurality of terminals (56) provided thereon which are electrically connected to circuit modules on the first circuit board; and
a heat sink (30) having front and rear surfaces provided adjacent the bus bar such that the bus bar is intermediate the heat sink and rear surface of the first circuit, board and the heat sink is thermally connected to the circuit modules (18) such that the heat sink is adapted to thermally conduct heat away from the circuit modules; and
a cover (60) on the front surface of the heat sink, the cover having at least one aperture (68) formed therein for receipt of at least one terminal extending from the bus bar to at least one of the circuit modules of the first circuit board, so that the buss bar can be electrically connected to circuit modules provided on the first circuit board.

9. An electrical circuit board assembly according to claim 8 wherein the cover, in cooperation with the heat sink, substantially encloses the bus bar.

10. An electrical circuit board assembly according to claim 8 and further comprising insulating material provided between the cover and the bus bar such that the bus bar and heat sink are electrically insulated from one another.

11. An electrical circuit board assembly according to claim 10 and further comprising insulating material provided between the heat sink and busj bar such that the bus bar and heat sink are electrically insulated from one another.

12. An electrical circuit board assembly comprising:
first and second circuit boards (14,16) each having at least one circuit module (18) provided thereon;
a bus bar (20) provided intermediate the two circuit boards, the bus bar having a plurality of terminals (56) provided thereon which are electrically connected to circuit modules on both the first and second circuit boards;
a heat sink (30) provided intermediate the two circuit boards, the heal sink being thermally connected to the circuit modules and adapted to thermally conduct heat away from the circuit modules, the heat sink having at least one aperture (72) provided therein for the receipt of at least one buss bar terminal extending from the buss bar to at least one of the circuit modules of the second circuit board and a depression (42) formed in a front surface thereof, the depression being adapted to receive at least a portion of the bus bar therein;
insulating material (64) provided between the heat sink and bus bar such that the bus bar and heat sink are electrically insulated from one another;
a cover (60) provided on the front surface of the heat sink, the cover having at least one aperture (68) formed therein for receipt of at least one terminal extending front the bus bar to at least one of the circuit modules of the first circuit board; and insulating material (62) provided between the cover and the bus bar such that the bus bar and heat sink are electrically insulated from one another.

## Patentansprüche

1. Leiterplatten-Anordnung mit einer ersten Leiterplatte (14) mit einer Vorderfläche und einer Rückfläche, einer zweiten Leiterplatte (16) mit einer Vorderfläche und einer Rückfläche, wobei die Leiterplatten parallel zueinander derart vorgesehen sind, dass die Rückflächen entgegengesetzt und benachbart zueinander sind, und mehreren Schaltmodulen (18), die an wenigstens einer der Oberflächen der ersten und zweiten Leiterplatte vorgesehen sind, wobei die Anordnung ferner folgendes aufweist:
eine Steckleiste (20), die zwischen der ersten und der zweiten Leiterplatte und benachbart zu der Rückfläche der ersten Leiterplatte vorgesehen ist, wobei die Steckleiste elektrisch mit wenigstens einem der Schaltmodule, die an der ersten Leiterplatte vorgesehen sind, und wenigstens einem der Schaltmodule verbunden ist, die an der zweiten Leiterplatte vorgesehen sind;
einen Kühlkörper (30), der zwischen der ersten und der zweiten Leiterplatte vorgesehen ist und benachbart an sowohl die Steckleiste als auch die Rückfläche der zweiten Leiterplatte vorgesehen ist, wobei der Kühlkörper dafür angepasst ist, Wärme von der Steckleiste und den Schaltmodulen thermisch wegzuführen, und eine Vorder- und eine Rückfläche aufweist; und
eine Abdeckung (60), die an der Vorderfläche des Kühlkörpers vorgesehen ist, wobei die Abdeckung wenigstens eine Öffnung (68) aufweist, die darin für die Aufnahme einer elektrischen Verbindung ausgebildet ist, die sich zwischen der Steckleiste und wenigstens einem der Schaltmodule der ersten Leiterplatte erstreckt, so dass die Steckleiste elektrisch mit den Schaltmodulen verbunden werden kann, die sowohl an der ersten als auch an der zweiten Leiterplatte vorgesehen sind.

2. Leiterplatten-Anordnung nach Anspruch 1, wobei acht Öffnungen in der Abdeckung ausgebildet sind, und acht Schaltmodule an der ersten Leiterplatte vorgesehen und durch acht Verbindungsleitungen, die sich durch die acht Öffnungen zwischen der Steckleiste und der Abdeckung erstrecken, elektrisch mit der Steckleiste verbunden sind.

3. Leiterplatten-Anordnung nach Anspruch 1, wobei die Abdeckung in Zusammenwirkung mit dem Kühlkörper die Steckleiste im wesentlichen umschließt.

4. Leiterplatten-Anordnung nach Anspruch 1, ferner mit Isolationsmaterial, das zwischen der Abdeckung und der Steckleiste derart vorgesehen ist, dass die Steckleiste und der Kühlkörper elektrisch voneinander isoliert sind.

5. Leiterplatten-Anordnung nach Anspruch 4, ferner mit Isolationsmaterial (62, 64), das zwischen dem Kühlkörper und der Steckleiste derart vorgesehen ist, dass die Steckleiste und der Kühlkörper elektrisch voneinander isoliert sind.

6. Leiterplatten-Anordnung mit einer ersten Leiterplatte (14) mit einer Vorderfläche und einer Rückfläche, einer zweiten Leiterplatte (16) mit einer Vorderfläche und einer Rückfläche, wobei die Leiterplatten parallel zueinander derart vorgesehen sind, dass ihre Rückflächen entgegengesetzt und zueinander benachbart sind, und mehreren Schaltmodulen (18), die an wenigstens einer der Oberflächen der ersten und zweiten Leiterplatte vorgesehen sind, wobei die Anordnung folgendes aufweist:
eine Steckleiste (20), die zwischen der ersten und der zweiten Leiterplatte und benachbart zu der Rückfläche der ersten Leiterplatte vorgesehen ist, wobei die Steckleiste elektrisch mit wenigstens einem der Schaltmodule (18), die an der ersten Leiterplatte vorgesehen sind, und wenigstens einem der Schaltmodule verbunden ist, die an der zweiten Leiterplatte vorgesehen sind;
einen Kühlkörper (30), der zwischen der ersten und der zweiten Leiterplatte vorgesehen ist und benachbart an sowohl die Steckleiste als auch die Rückfläche der zweiten Leiterplatte vorgesehen ist, wobei der Kühlkörper dafür angepasst ist, Wärme von der Steckleiste und den Schaltmodulen thermisch wegzuführen; und
eine Abdeckung (60), die an der Vorderfläche des Kühlkörpers vorgesehen ist, wobei die Abdeckung wenigstens eine Öffnung (68) aufweist, die darin für die Aufnahme einer elektrischen Verbindung ausgebildet ist, die sich zwischen der Steckleiste und wenigstens einem der Schaltmodule der ersten Leiterplatte erstreckt, so dass die Steckleiste elektrisch mit Schaltmodulen verbunden werden kann, die sowohl an der ersten als auch an der zweiten Leiterplatte vorgesehen sind;
wobei der Kühlkörper (30) acht Öffnungen (72) aufweist, und acht Schaltmodule an der zweiten Leiterplatte vorgesehen sind und elektrisch mit der Steckleiste durch acht elektrische Verbindungsleitungen verbunden sind, die sich durch die acht Öffnungen zwischen der Steckleiste und dem Kühlkörper erstrecken.

7. Leiterplatten-Anordnung nach Anspruch 6, wobei acht Schaltmodule an der ersten Leiterplatte vorgesehen sind und elektrisch mit der Steckleiste verbunden sind.

8. Leiterplatten-Anordnung mit:
einer ersten Leiterplatte (14), mit einer Vorderfläche, einer Rückfläche und wenigstens einem Schaltmodul (18), das elektrisch mit wenigstens einer, der Vorder- und/oder der Rückfläche verbunden ist,
einer Steckleiste (20), die an die Rückfläche der ersten Leiterplatte benachbart vorgesehen ist, wobei die Steckleiste mehrere Anschlüsse (56) aufweist, die daran vorgesehen sind und elektrisch mit Schaltmodulen an der ersten Leiterplatte verbunden sind; und
einem Kühlkörper (30) mit einer Vorder- und einer Rückfläche, der benachbart zu der Steckleiste derart vorgesehen ist, dass sich die Steckleiste zwischen dem Kühlkörper und der Rückfläche der ersten Leiterplatte befindet, und der Kühlkörper thermisch mit den Schaltmodulen (18) derart verbunden ist, dass der Kühlkörper dafür angepasst ist, Wärme thermisch von den Schaltmodulen wegzuleiten; und
einer Abdeckung (60) an der Vorderfläche des Kühlkörpers, wobei die Abdeckung wenigstens eine Öffnung (68) aufweist, die darin für die Aufnahme wenigstens eines Anschlusses ausgebildet ist, der sich von der Steckleiste zu wenigstens einem der Schaltmodule der ersten Leiterplatte erstreckt, so dass die Steckleiste elektrisch mit Schaltmodulen verbunden werden kann, die an der ersten Leiterplatte vorgesehen sind.

9. Leiterplatten-Anordnung nach Anspruch 8, wobei die Abdeckung in Zusammenwirkung mit dem Kühlkörper die Steckleiste im wesentlichen umschließt.

10. Leiterplatten-Anordnung nach Anspruch 8, ferner mit Isolationsmaterial, das zwischen der Abdeckung und der Steckleiste derart vorgesehen ist, dass die Steckleiste und der Kühlkörper elektrisch voneinander isoliert sind.

11. Leiterplatten-Anordnung nach Anspruch 10, ferner mit Isolationsmaterial, das zwischen dem Kühlkörper und der Steckleiste vorgesehen ist, so dass die Steckleiste und der Kühlkörper elektrisch voneinander isoliert sind.

12. Leiterplatten-Anordnung mit:
ersten und zweiten Leiterplatten (14, 16), die jeweils wenigstens ein Schaltmodul (18) aufweisen, das daran vorgesehen ist;
einer Steckleiste (20), die zwischen den beiden Leiterplatten vorgesehen ist, wobei die Steckleiste mehrere Anschlüsse (56) aufweist, die daran vorgesehen sind und elektrisch mit Schaltmodulen an sowohl der ersten als auch der zweiten Leiterplatte verbunden sind;
einem Kühlkörper (30), der zwischen den beiden Leiterplatten vorgesehen ist, wobei der Kühlkörper thermisch mit den Schaltmodulen verbunden ist und dafür angepasst ist, Wärme von den Schaltmodulen thermisch wegzuleiten, wobei der Kühlkörper wenigstens eine Öffnung (72), die darin für die Aufnahme wenigstens eines Steckleistenanschlusses vorgesehen ist, der sich von der Steckleiste zu wenigstens einem der Schaltmodule der zweiten Leiterplatte erstreckt, und eine Vertiefung (42) aufweist, die in einer Vorderfläche derselben ausgebildet ist, wobei die Vertiefung dafür angepasst ist, wenigstens einen Abschnitt der Steckleiste darin aufzunehmen;
Isolationsmaterial (64), das zwischen dem Kühlkörper und der Steckleiste derart vorgesehen ist, dass die Steckleiste und der Kühlkörper elektrisch voneinander isoliert sind;
einer Abdeckung (60), die an der Vorderfläche des Kühlkörpers vorgesehen ist, wobei die Abdeckung wenigstens eine Öffnung (68) aufweist, die darin für die Aufnahme wenigstens eines Anschlusses ausgebildet ist, der sich von der Steckleiste zu wenigstens einem der Schaltmodule der ersten Leiterplatte erstreckt; und
Isolationsmaterial (62), das zwischen der Abdeckung und der Steckleiste derart vorgesehen ist, dass die Steckleiste und der Kühlkörper elektrisch voneinander isoliert sind.

## Revendications

1. Ensemble de cartes de circuit électrique comprenant une première carte de circuit (14) qui possède une surface avant et une surface arrière, une deuxième carte de circuit (16) qui possède une surface avant et une surface arrière, les cartes de circuit étant disposées parallèlement l'une à l'autre de façon que leurs surfaces arrière soient mutuellement opposées et adjacentes, et une pluralité de modules de circuit (18) placés sur au moins l'une des surfaces des première et deuxième cartes de circuit, l'ensemble comprenant en outre :
une barre omnibus (20) disposée entre les première et deuxième cartes de circuit et adjacente à la surface arrière de la première carte de circuit, la barre omnibus étant électriquement connectée à au moins un des modules de circuit placés sur la première carte de circuit et à au moins un des modules de circuit placés sur la deuxième carte de circuit ;
un puits de chaleur (30) placé entre les première et deuxième cartes de circuit et adjacent à la fois à la barre omnibus et à la surface arrière de la deuxième carte de circuit, le puits de chaleur étant destiné à conduire thenniquement la chaleur émanant de la barre omnibus et des modules de circuit afin de l'éloigner de ceux-ci et comprenant des surfaces avant et amère ; et
un couvercle (60) placé sur la surface avant du puits de chaleur, le couvercle comportant au moins une ouverture (68) qui y est formée pour recevoir une connexion électrique s'étendant entre la barre omnibus et au moins un des modules de circuit de la première carte de circuit, de façon que la barre omnibus puisse être électriquement connectée à des modules de circuit placés sur les première et deuxième cartes de circuit.

2. Ensemble de cartes de circuit électrique selon la revendication 1, où huit ouvertures sont formées dans le couvercle et huit modules de circuit sont placés sur la première carte de circuit et sont électriquement connectés à la barre omnibus via huit conduits de connexion électrique s'étendant, via les huit ouvertures, entre la barre omnibus et le couvercle.

3. Ensemble de cartes de circuit électrique selon la revendication 1, où le couvercle, en coopération avec le puits de chaleur, enclot sensiblement la barre omnibus.

4. Ensemble de cartes de circuit électrique selon la revendication 1, comprenant en outre une matière isolante disposée entre le couvercle et la barre omnibus, de sorte que la barre omnibus et le puits de chaleur sont électriquement isolés l'un de l'autre.

5. Ensemble de cartes de circuit électrique selon la revendication 4, comprenant en outre une matière isolante (62, 64) disposée entre le couvercle et la barre omnibus, de sorte que la barre omnibus et le puits de chaleur sont électriquement isolés l'un de l'autre.

6. Ensemble de cartes de circuit électrique comprenant une première carte de circuit (14) qui possède une surface avant et une surface arrière, une deuxième carte de circuit (16) qui possède une surface avant et une surface arrière, les cartes de circuit étant disposées parallèlement l'une à l'autre de façon que leurs surfaces arrière soient mutuellement opposées et adjacentes, et une pluralité de modules de circuit (18) placés sur au moins l'une des surfaces des première et deuxième cartes de circuit, l'ensemble comprenant en outre :
une barre omnibus (20) disposée entre les première et deuxième cartes de circuit et adjacente à la surface arrière de la première carte de circuit, la barre omnibus étant électriquement connectée à au moins un des modules de circuit (18) placés sur la première carte de circuit et à au moins un des modules de circuit placés sur la deuxième carte de circuit ;
un puits de chaleur (30) placé entre les première et deuxième cartes de circuit et adjacent à la fois à la barre omnibus et à la surface arrière de la deuxième carte de circuit, le puits de chaleur étant destiné à conduire thermiquement la chaleur émanant de la barre omnibus et des modules de circuit afin de l'éloigner de ceux-ci ;
un couvercle (60) placé sur la surface avant du puits de chaleur, le couvercle comportant au moins une ouverture (68) qui y est formée pour recevoir une connexion électrique s'étendant entre la barre omnibus et au moins un des modules de circuit de la première carte de circuit, de façon que la barre omnibus puisse être électriquement connectée à des modules de circuit placés sur les première et deuxième cartes de circuit ;
le puits de chaleur (30) comprenant huit ouvertures (72), tandis que huit modules de circuits sont placés sur la deuxième carte de circuit et sont électriquement connectés à la barre omnibus par l'intermédiaire de huit conduits de connexion électrique s'étendant, au travers des huit ouvertures, entre la barre omnibus et le puits de chaleur.

7. Ensemble de cartes de circuit électrique selon la revendication 6, où huit modules de circuits sont placés sur la première carte de circuit et sont électriquement connectés à la barre omnibus.

8. Ensemble de cartes de circuit électrique comprenant :
une première carte de circuit (14) qui possède une surface avant, une surface arrière et au moins un module de circuit (18) électriquement connecté à au moins l'une des surfaces avant et arrière ;
une barre omnibus (20) placée au voisinage de la surface arrière de la première carte de circuit, la barre omnibus possédant une pluralité de bornes (56), placées sur celle-ci, qui sont électriquement connectées à des modules de circuit se trouvant sur la première carte de circuit ;
un puits de chaleur (30) qui possède des surfaces avant et arrière disposées au voisinage de la barre omnibus de façon que la barre omnibus soit disposée entre le puits de chaleur et la surface arrière de la première carte de circuit et que le puits de chaleur soit thermiquement connecté aux modules de circuit (18) de sorte que le puits de chaleur est en mesure de conduire thermiquement la chaleur afin de l'écarter des modules de circuit ; et
un couvercle (60) disposé sur la surface avant du puits de chaleur, le couvercle ayant au moins une ouverture (68) formée dans celui-ci afin de recevoir au moins une borne qui s'étend de la barre omnibus jusqu'à au moins l'un des modules de circuit de la première carte de circuit, de sorte que la barre omnibus peut être électriquement connectée à des modules de circuit placés sur la première carte de circuit.

9. Ensemble de cartes de circuit électrique selon la revendication 8, où le couvercle, en coopération avec le puits de chaleur, enclot sensiblement la barre omnibus.

10. Ensemble de cartes de circuit électrique selon la revendication 8, comprenant en outre une matière isolante disposée entre le couvercle et la barre omnibus, de sorte que la barre omnibus et le puits de chaleur sont électriquement isolés l'un de l'autre.

11. Ensemble de cartes de circuit électrique selon la revendication 10, comprenant en outre une matière isolante disposée entre le couvercle et la barre omnibus, de sorte que la barre omnibus et le puits de chaleur sont électriquement isolés l'un de l'autre.

12. Ensemble de cartes de circuit électrique comprenant :
des première et deuxième cartes de circuit (14, 16), sur chacune desquelles se trouve au moins un module de circuit (18) ;
une barre omnibus (20) disposée entre les deux cartes de circuit, la barre omnibus ayant une pluralité de bornes (56) placées sur celle-ci, qui sont électriquement connectées à des modules de circuit se trouvant aussi bien sur la première carte de circuit que sur la deuxième carte de circuit ;
un puits de chaleur (30) disposé entre les deux cartes de circuit, le puits de chaleur étant thermiquement connecté aux modules de circuit et étant en mesure de conduire thermiquement la chaleur afin de l'éloigner des modules de circuit, le puits de chaleur ayant au moins une ouverture (72) disposée dans celui-ci afin de recevoir au moins une borne de la barre omnibus, qui s'étend de la barre omnibus à au moins l'un des modules de circuit de la deuxième carte de circuit et un creux (42) formé dans une surface avant du puits de chaleur, le creux étant destiné à recevoir une partie de la barre omnibus ;
une matière isolante (64) disposée entre le puits de chaleur et la barre omnibus de façon que la barre omnibus et le puits de chaleur soient électriquement isolés l'un de l'autre ;
un couvercle (60) disposé sur la surface avant du puits de chaleur, le couvercle ayant au moins une ouverture (68) qui est formée dans celui-ci pour recevoir au moins une borne s'étendant de la barre omnibus jusqu'à au moins l'un des modules de circuit de la première carte de circuit ; et
une matière isolante (62) disposée entre le couvercle et la barre omnibus de façon que la barre omnibus et le couvercle soient électriquement isolés l'un de l'autre.
